# EUROPEAN PATENT SPECIFICATION

(11) **EP 4 170 904 B1**
(45) Date of publication and mention of the grant of the patent: **14.10.2026**
(21) Application number: 22191327.0
(22) Date of filing: 19.08.2022
(51) Int. Cl.: H03K 3/356

(54) **SCALABLE EOS AND AGING TOLERANT LEVEL SHIFTER FOR A HIGH VOLTAGE DESIGN FOR THIN GATE TECHNOLOGY**
SKALIERBARER EOS- UND ALTERUNGSTOLERANTER PEGELSCHIEBER FÜR EIN HOCHSPANNUNGSDESIGN FÜR DÜNNGATETECHNOLOGIE
EOAS ÉVOLUTIF ET DISPOSITIF DE DÉCALAGE DE NIVEAU TOLÉRANT AU VIEILLISSEMENT POUR UNE CONCEPTION HAUTE TENSION POUR UNE TECHNOLOGIE DE GRILLE MINCE

(30) Priority: 23.09.2021 US 202117482912
(43) Date of publication of application: 26.04.2023
(73) Proprietor: Intel Corporation, Santa Clara, CA 95054 (US)
(72) Inventor: DUA, Raj, Newark 94560 (US); VENKATANARAYANAN, Hari Vijay, 560066 Bengaluru (IN)
(74) Representative: HGF

(56) References cited:
- US-A1- 2011 254 591
- US-A1- 2013 141 140
- US-A1- 2016 164 497

## Description

### TECHNICAL FIELD

The document pertains generally, but not by way of limitation, to integrated circuits, and more particularly, to techniques for a voltage level shifter.

### BACKGROUND

Microprocessors and other data processing devices typically include core logic circuitry, such as circuitry that is configured to execute software applications or to perform data processing operations, and input-output (I/O) interface circuitry, such as circuitry that is configured to interface with, or to exchange data or other signals between, devices that are external or remote to the microprocessor. To reduce power dissipation and to, among other things, enable the continuing reduction in integrated circuitry device sizes, microprocessor core logic circuitry is typically operated at or about the minimum voltage (hereinafter, "core voltage") allowable by a semiconductor fabrication process node. Input-output circuitry, however, generally operate at voltages (hereinafter, "I/O voltage" or "I/O voltages") higher than this core voltage, such as to improve signal integrity or to enable high speed communication over the relatively long distances between devices or components of a system. A voltage level shifter, such as the high-speed level shifters typically employed in high-speed memory I/O interface such as double data rate (DDR) memory and high bandwidth memory (HBM), are used in processors to convert, or shift the voltages of signals generated by core logic circuitry to voltages in the range of the I/O circuitry.

A concern in the implementation of level shifter circuitry is electrical over stress (EOS) and device aging, such as caused by applying a voltage a cross a device (e.g., across two terminals of a device) that exceeds an operating parameter of the devices, such as an EOS target or threshold voltage of a transistor. EOS can degrade the performance of a device and accelerate device aging. Several techniques for building level shifters attempt to address these concerns. One technique, for example, includes the use of thick gate devices, such as semiconductor devices that have a gate oxide that is suitably thick to cause the devices to have an EOS target of threshold that exceeds the range of I/O voltages used in I/O interface circuitry. Another technique includes the use of thin gate devices, such as devices that may be susceptible to EOS damage when operated at voltages in the range of I/O voltages used in I/O interface circuitry, along with an elevated ground signal, such as a reference signal that is offset to a higher voltage than a ground or reference used by the core logic, to protect devices that are exposed to I/O voltages. Such device protection includes using the elevated reference to limit maximum voltage across the device.

US 2013/141140 A1 discloses an output driver circuit includes first, second, third, and fourth transistors having a common current path, wherein a gate of the first transistor receives a first switching signal, a gate of the second transistor receives a first reference voltage, a gate of the third transistor receives a second reference voltage, and a gate of the fourth transistor receives a second switching signal, and wherein a first capacitor is coupled between the gate of the first transistor and the gate of the third transistor, a second capacitor is coupled between the gate of the second transistor and the gate of the fourth transistor, and an output signal is provided at a node coupling the second and third transistors.

Document US 2011/254591 A1 shows in Fig. 1(b) a dynamic driver reference generator to generate a plurality of dynamic driver reference signals based on a data signal and an IO buffer supply voltage and a level shifter.

Document US 2016/164497 A1 shows a circuit structure for minimizing bias temperature instability (BTI) degradation of the circuit structure.

### SUMMARY

The invention is defined by the appended claims.

### BRIEF DESCRIPTION OF THE DRAWINGS

In the drawings, which are not necessarily drawn to scale, like numerals may describe similar components in different views. Like numerals having different letter suffixes may represent different instances of similar components. Some examples are illustrated by way of example, and not limitation, in the figures of the accompanying drawings.
FIG. 1 includes a diagram of an example of a level shifter that includes one or more pulldown p-channel field effect transistors.
FIG. 2 illustrate a diagram of an example of circuitry for using a p-channel field effect transistor in a pulldown configuration to provide EOS protection to one or more p-channel field effect transistors in level shifter.
FIG. 3 illustrates a diagram of an example of circuitry for using a two or more p-channel field effect transistors in a pulldown configuration to provide EOS protection to one or more p-channel field effect transistors in level shifter.
FIG. 4 illustrates a diagram of an example of a level shifter that uses pulldown p-channel field effect transistors to provide EOS protection.
FIG. 5 illustrates a diagram of an example of a level shifter that uses pulldown p-channel field effect transistors to provide EOS protection.
FIG. 6 illustrates a diagram of an example of output circuitry for a I/O interface that includes a level shifter and formed by thin p-channel field effect transistors.
FIG. 7 illustrates steps for a process 700 for forming a level shifter that provides EOS protection to thin gate devices.

### DETAILED DESCRIPTION

Aspects of the present disclosure are based on the inventors' realization that existing techniques for shifting the voltage level of signals in an integrated circuit from a low voltage range, such as a core voltage range, to a higher voltage range, such as an I/O voltage range, is not suitable for some applications and can inhibit or limit progress in current trends towards forming smaller, faster, and lower power integrated circuit devices and systems. In example, fabrication costs associated with level shifting techniques that use thick gate devices can be high as such techniques can require a semiconductor manufacturer to support or implement both thick gate and thin gate fabrication technologies. These costs can be prohibitive as many semiconductor manufacturers, such as companies having a microprocessor or device chipset business, prefer to use a single technology, such as thin gate device technology, to optimize manufacturing costs and to maximize device performance. In another example, level shifting techniques that use thin gate devices with an elevated reference can incur increased manufacturing costs, such as in terms of die area, power consumption, engineering design and support efforts. Additionally, such techniques may be challenging to scale higher data rates. In another example, generating and using an elevated reference can consume a large amount of die area due to the addition of analog circuitry, such as voltage regulators, added power supply tracks or wires, and the addition of capacitor banks and other devices for noise suppression. Such techniques can also experience increased power consumption, such as due to current leakage caused by the elevated reference leaving some devices partially turned on while a device is energized. This can require increases to a device's power budget which can limit the ability to scale such devices to higher data rates. Engineering costs can also be increased due to the need to design, validate, and tune the additional analog circuitry.

Aspects of the present disclosure include techniques (e.g., circuits, devices, systems, or methods) for an EOS and aging robust level shifter that addresses the disadvantages of existing level shifter techniques. In an example, the techniques disclosed herein include a level shifter formed using thin gate devices (e.g., transistors) that are protected from EOS by one or more thin gate p-channel field effect transistors (PFETs) that are configured as pulldown devices. Such PFETs are configured to limit or reduce the voltage across the protected devices by at least one PFET threshold voltage (Vₜₚ) drop below the high voltage supply of the level shifter. In an example, the PFETs in the pulldown configuration (hereinafter, "pulldown PFET" or "pulldown PFETs") generate gate signals for the protected PFET devices that have a voltage swing between the high supply voltage of the level shifter and at least one Vₜₚ drop above the voltage reference or ground rail of the level shifter. This technique can be used, such as by adding one or more additional Vₜₚ drops using one or more additional pulldown PFETs, to provide any suitable voltage drop to limit the EOS voltage across a protected device to an EOS target or threshold voltage.

In an example, a level shifter is fabricated using thin gate field effect transistors (FETs). The thin gate FETs include one or more pulldown PFETs that provide a constant voltage drop of at least one Vₜₚ to limit the voltage across PFETs that are exposed to the high voltage supply of the level shifter to a voltage below the EOS target or threshold for the devices. The voltage across the protected PFETs is limited or obtained by using the pulldown PFETs to generate gate signals for the protected devices that are at least one Vₜₚ drop above the reference voltage of the level shifter.

By using the pulldown PFETs to limit EOS voltage across thin FET devices, the level shifters formed according to the techniques described herein provide EOS and aging robustness without the use of thick gate devices or elevated ground supply references. This enables fabrication of EOS and aging robust level shifters using just a thin gate process, and eliminates the analog circuitry, increased die area, and associated analog design considerations that would otherwise be need for level shifters that use an elevated ground supply.

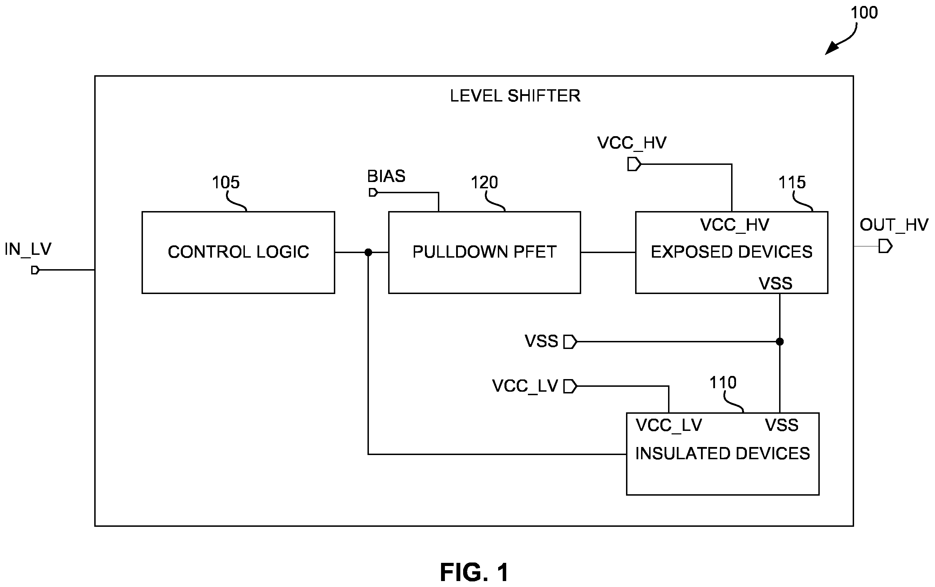

FIG. 1 includes a diagram of an example of a level shifter 100 that includes one or more pulldown PFETs. Level shifter 100 can include circuitry or a data structure, such as a circuit layout file of a computer aided design software application used in integrated circuit fabrication, for implementing any of the level shifters described herein. In an example, lever shifter 100 is used in microprocessor circuitry to convert the voltages of signals IN_LV generated by core logic circuitry of the microprocess to the voltage levels of I/O circuitry associated with the processor. The core logic can be configured to generate low voltage signals IN_LV that have voltage swings (e.g., a maximum voltage swing) between the low voltage supply rail VCC_LV and reference or ground rail VSS (hereinafter, "low voltage domain"). In an example, VSS_LV or the maximum voltage of IN_LV is less than a minimum indicated voltage for safely or reliably actuating or driving devices that are configured to operate with voltage swings between the high voltage supply VCC_HV and VSS (hereinafter, "high voltage domain"). Level shifter 100 is configured to receive VCC_LV, VCC_HV, VSS, and low voltage signal IN_LV. Level shifter 100 is further configured to shift the low voltage signal IN_LV to the high voltage signal OUT_HV, where OUT_HV has a voltage swing between VCC_HV and VSS. OUT_HV in various examples, has a maximum high voltage of VCC_HV and a maximum low voltage of VSS.

In an example, level shifter 100 includes control logic 105, insulated devices 110, exposed devices 115, and pulldown PFET 120. Each component of the level shifter 100, in various examples, is implemented using thin gate FETs. In other examples, level shifter 100 and one or more of its associated components are implemented using one or more other semiconductor device technology or process.

Control logic 105 includes circuitry that is configured to receive low voltage signal IN_LV (e.g., a signal in the core logic voltage domain) and to actuate, such as by providing biasing voltages or other control signals, one or more components of level shifter 100 to shift or convert IN_LV to high voltage output signal OUT_HV (e.g., a signal in the I/O voltage domain). In an example, the circuitry of control logic 105 is not exposed to VCC_HV. In other examples, control logic 105 includes devices is exposed to both VCC_HV and VCC_LV. In such examples, the exposed devices are protected by pulldown PFET 120, as described herein.

Insulated devices 110 include circuitry that is configured to be actuated or driven by control logic 105 to shift or convert IN_LV to high voltage output signal OUT_HV. In an example, insolated devices 110 includes devices that are coupled to VCC_LV and VSS and are insulated from, or are not exposed to, VCC_HV. Insulated devices 110 include, for example, control logic devices that are supplied by VCC_LV and VSS, and n-channel field effect transistors (NFETs) that form, or that are used to protect, the pulldown circuitry in the output stage of level shifter 100.

Exposed devices 115 include circuitry that is configured to be actuated or driven by control logic 105 to shift or convert IN_LV to high voltage output signal OUT_HV. Such circuitry, in various examples, include PFETs that are coupled to VCC_HV and VSS. Such PFETs can include PFETs that form the pullup circuitry in the output stage of the level shifter 100. Such PFETs can additionally include control logic PFETs that are configured to actuate the pullup circuitry or to steer signals to such circuitry.

Pulldown PFET 120 includes one or more PFETs that are configured as pulldown devices to provide EOS protection to exposed devices 115. Such protection includes, in various examples, pulldown PFET 120 generating gate signals that switch between VCC_HV and one or more Vₜₚ drops above VSS. In an example pulldown PFET 120 can include two or more PFET devices that are cascaded to provide a suitable number of Vₜₚ drops. ca Such protection includes, in other examples, pulldown PFET 120 providing a one or more Vtp drop between the drain of a PFET and a references node, such as VSS. This technique provides EOS protection by limiting the maximum gate-to-drain voltage V_{GD} or gate-to-source voltage V_{GS} a protected PFET to a value determined by VCC_HV and the number of Vₜₚ drops provided by PFET 120. The number of Vₜₚ drops (e.g., the number of cascaded PFETs) used to obtain a specified level of EOS protection can be determined based on, for example, the difference between VCC_HV (e.g., the maximum voltage that may be dropped across an exposed PFET in the level shifter 100) and an indicated EOS target or threshold voltage for the protected device. In an example, if VCC_HV is 1.133V and the PFETs in level shifter 100 has an EOS target of 0.9V, then two cascaded PFETs can be used to provide two Vtp voltage drop to satisfy the EOS target requirement. In some examples, pulldown PFET 120 includes one or more biasing or offsetting signals BIAS to adjust the level of EOS protection by selectively decreasing or increasing the gate biasing or drain voltage drop provided by pulldown FET 120.

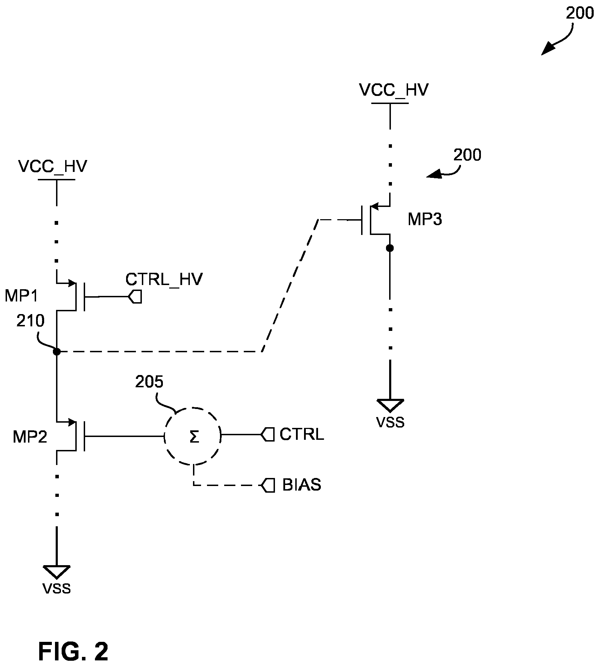

FIG. 2 illustrate a block diagram of an example of circuitry 200 for using a PFET MP2 in a pulldown configuration to provide EOS protection to one or more PFETs MP1 and MP3 in level shifter. Circuitry 200 is an example of circuitry that can be used in level shifter 100, such as to protect exposed devices 115. Circuitry 200 includes PFETs MP1, MP2, and MP3. In some examples, circuitry 200 includes bias circuitry 205. Bias circuitry 205 can include any circuitry that is configured to add a voltage bias to control signal CRTL used to drive the gate of MP2.

Transistors MP1 and MP3 are examples of exposed PFET devices, such as exposed devices 115, that are exposed to a voltage supply having a reference voltage rail VSS and a high voltage rail VCC_HV that exceeds an EOS target or threshold voltage of the devices. Such devices may be susceptible to EOS due to their connection across VCC_HV and VSS.

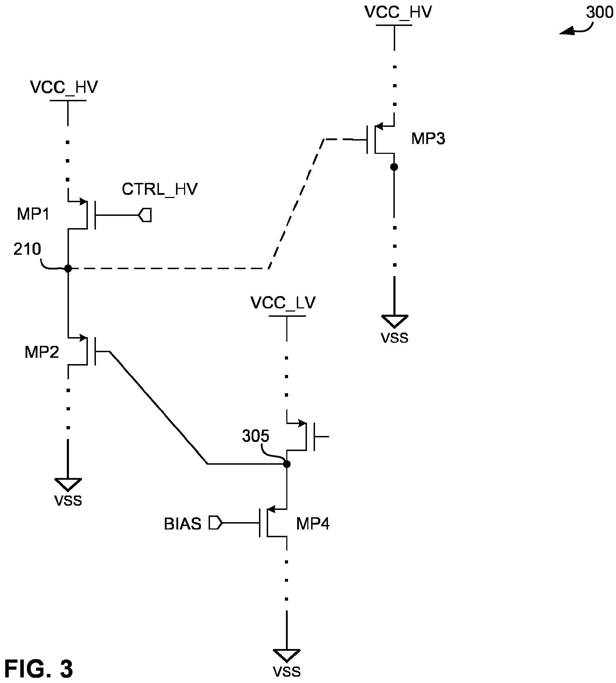

Transistor MP2 is an example of a PFET, such as pulldown PFETs 120, that is configured or arranged in a pulldown configuration to provide EOS protection to MP1 and MP3. As shown in FIG. 2, MP2 is configured as a pulldown transistor (e.g., MP2 has a pulldown configuration) as it is deployed in a stacked configuration and its source is not coupled to the high voltage rail VCC_HV. MP2 has a gate that is driven by control signal CTRL and, optionally, bias or offset signal BIAS. In an example, CTRL is combined with BIAS such that the gate voltage V_{G} of MP2 is the sum, or another suitable aggregation function determined by biasing circuitry 205, of the voltages of CTRL and BIAS. Unless indicated otherwise, CTRL is assumed to include BIAS for the remainder of this discussion. CTRL drives the gate of MP2 such that MP2 turns on or conducts when the source voltage V_{S} of MP2 exceeds V_{G} (e.g., voltage of CTRL) by Vₜₚ (e.g., the threshold voltage of MP2) and MP2 is turned off when V_{S} drops below the sum of V_{G} and Vₜₚ. In this pulldown configuration, MP2 is configured to pull the voltage at node 210 towards VSS responsive to the V_{G} going, or being driven, low (e.g., V_{G} having a value of VSS or 0V). Transistor MP2 will not be able to pull node 210 to VSS at the transistor will turn off once the voltage at node 210 (e.g., V_{S}) is pulled below the voltage CTRL + Vₜₚ. Accordingly, the minimum value of the voltage at node 210 is CTRL + Vₜₚ. This value is smallest when MP2 fully turned on. Since MP2 is typically driven to turn on fully by driving CTRL low, or to 0V, the minimum voltage at node 210 is Vₜₚ, or the sum of Vₜₚ and BIAS. This minimum voltage can be increased by any integer multiple of Vₜₚ by cascading two or more pulldown PFETs, such as shown in FIG. 3.

In operation, transistors MP1, MP3 can experience EOS when a voltage across any two terminals of the devices exceeds an EOS target or threshold for the device. In a configuration of circuitry 200 where VCC_HV exceeds, or is higher than the EOS target of MP1 or MP3, transistor MP2 can protect each of these devices by ensuring a minimum voltage at node 210.

In an example, MP2 protects MP3 from gate-to-source voltage (V_{GS}) EOS by providing or ensuring a specified minimum voltage at the gate of MP3 (e.g., the voltage at node 210). If, for example, VCC_HV is within one Vₜₚ of the gate-to-source EOS target of MP3, then a one Vₜₚ minimum voltage provided by MP2 at node 210 ensures that the V_{GS} of MP3 doesn't exceed the EOS target, thereby limiting the likelihood of V_{GS} EOS. Without MP2, V_{GS} of MP3 could exceed the EOS target, such as when the V_{G} of MP3 is driven to 0V to turn on the transistor. In another example, if VCC_HV is within two Vtp of the gate-to-source EOS target of MP3, then two transistors MP2 can be cascaded, such as shown in FIG. 3, to provide a two Vₜₚ minimum voltage at node 210, ensuring that the V_{GS} of MP3 does not exceed the EOS target, thereby limiting the likelihood of V_{GS} EOS. A pulldown PFET mirroring MP2 can be used to provide similar V_{GS} EOS protection to M1.

In another example, MP2 protects MP3 from gate-to-drain (V_{GD}) EOS by providing or ensuring a specified the minimum voltage at the drain of MP3 (e.g., node 210). In an example where MP2 is not included in circuitry 200, V_{GD} can exceed the gate-to-drain EOS target of MP1, such as when V_{G} of MP1 is driven high to VCC_HV. Transistor MP2, or one or more cascaded versions of MP2, can protect MP1 from V_{GD} by ensuring a specified minimum voltage at the drain of MP1 that is an indicated multiple of Vₜₚ. A pulldown PFET mirroring MP2 disposed between the drain of MP3 and VSS can be used to provide similar V_{GD} EOS protection to MP3.

FIG. 3 illustrates a diagram of an example of circuitry 300 for using a two or more PFETS in a pulldown configuration to provide EOS protection to one or more PFETs MP1 and MP3 in level shifter. Circuitry 300 is an example of circuitry 200, modified to include a second pulldown PFET MP4 to provide an additional Vₜₚ drop at node 210, such as to increase the minimum voltage at node 210 to 2×Vₜₚ. As shown in FIG. 3, MP4 is coupled to the voltage supply VCC_LV. In some, examples, however, MP4 can be coupled to VCC_HV.

In operation, the pulldown operation of MP4 provides a minimum voltage at node 305 of Vₜₚ. This minimum voltage is coupled to the gate of MP2, thereby providing a minimum voltage at node 210 is 2×Vtp.

MP4 is additionally configured as an example of bias circuit 205, such as by providing a means to offset the voltage at the gate of MP2, or at nodes 210 or 305, by bias signal BIAS. In an example BIAS, as shown in FIGS. 2 and 3, is generated locally, such as within the level shifter or on a microprocessor die, and has a selectable or adjustable value that can be used to provide additional EOS protection margin, such as by setting or determining a higher minimum valve for the nodes 210 or 305. In an example BIAS has a value between 0V and 250mV.

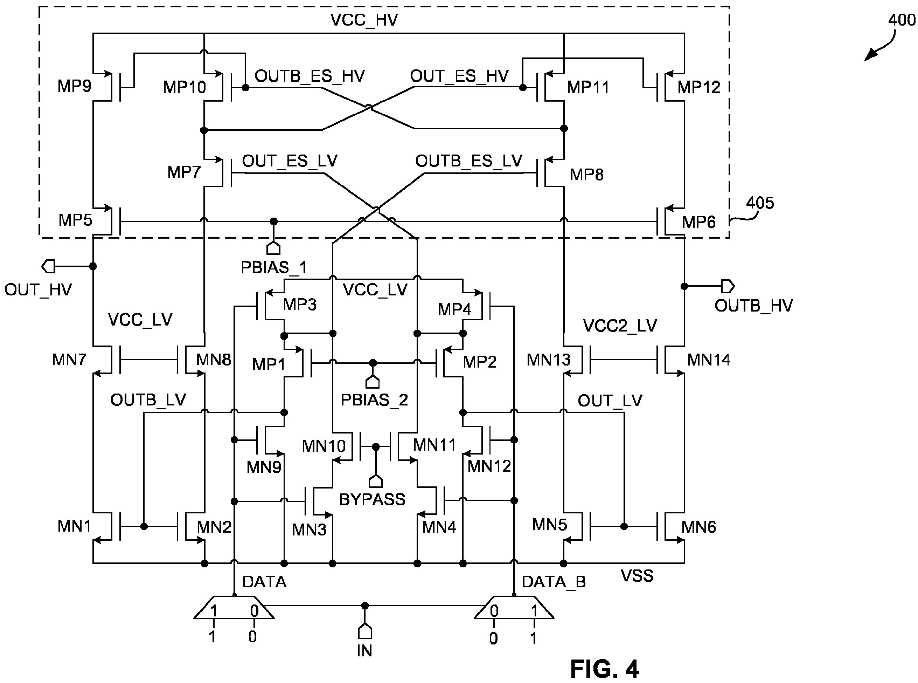

FIG. 4 illustrates a diagram of an example of a level shifter 400 that uses pulldown PFETs to provide EOS protection. Level shifter 400 is an example of level shifter 100 (FIG. 1), and is configured to shift, for example, digital input signals IN that switch between low voltage domain voltage rails VCC_LV and VSS to output signals OUT_HV or OUTB_HV that switch between a high voltage domain rails VCC_HV and VSS. In an example, level shifter 400 is formed using thin FETs, such that the EOS target or threshold of the FETs are less than the voltage difference between VCC_HV and VSS. Level shifter 400 is further configured to use a single reference VSS (e.g., a 0V or true ground reference) to perform the indicated level shifting operations.

As shown in FIG. 4, circuitry 405 includes one or more devices that are exposed to VCC_HV, and therefore require EOS protection. In an example, PFET devices MP5-MP12 are exposed to VCC_HV, while NFETs MN1-MN14 are insulated from this voltage rail. PFETs MP1-MP4 are similarly insulated or isolated from VCC_HV and therefore do you require additional EOS protection. Transistors MP1, MP2, MP5, MP6, MP7, and MP8 are configured as pulldown PFETs, such as MP2 (FIG. 2) and MP4 (FIG. 3), to provide EOS protection to MP9, MP10, MP11, and MP12.

In operation, level shifter 400 is configured to operate in a normal mode, such as for level shifters formed using FETs that have a low Vₜₚ (e.g., thin FETS having a threshold voltage between .1-.3V) and a bypass mode, such as for level shifters formed using FETs having a large Vₜₚ (e.g., a threshold voltage that exceeds the low Vₜₚ range ). In an example, the level shifter mode of operation is selected through actuation of signal BYPASS.

Gate-to-source voltage EOS can be caused by a voltage between the gate and source of a PFET that exceeds an EOS target or threshold, such as when the transistors turned-on (e.g., V_{G} is at or approaches a low voltage, such as VSS). In normal mode, V_{GS} EOS protection for MP9, MP10, MP11, and MP12 is provided by gate signals that switch between VCC_HV and 2×Vₜₚ above bias voltage pbias_2, where pbias_2 is a gate offset voltage such as BIAS (FIGS. 2 and 3). Bias voltage pbias_2 controls the level of V_{GS} EOS protection provided in normal mode. As pbias_2 is increased, the voltage at the source of, for example, MP1 or MP2, is increased thereby increasing the voltage at the gate of MP7 or MP8. This in turn increases the voltage at the gates of MP9, MP10, MP11, and MP12, thereby reducing V_{GS} of these transistors, such as when the transistors are actuated to turn on. Reduced V_{GS} corresponds to improved VGS EOS protection. In an example, pbias_2 can be adjusted between 0V-250mV.

A gate voltage OUT_ES_HV and OUTB_ES_HV that is 2×Vₜₚ above pbias_2 is obtained at the gates of MP9, MP10, MP11, and MP12 are obtained as follows. Transistors MP1 and MP2 generates complementary signals OUT_ES_LV and OUTB_ES_LV at the source of these transistors. Signals OUT_ES_LV and OUTB_ES_LV switch between VCC_LV and pbias_2+Vtp, such as due to the pulldown configuration of the MP1 and MP2. Pulldown FETs MP7 and MP8 provide an additional Vₜₚ to the voltage drop between their gate and source nodes to provide a minimum voltage of pbias_2+2×Vₜₚ at their source, thereby ensuring that the gate voltages of MP9, MP10, MP11, and MP12 swing between VCC_HV and pbias_2+2×Vₜₚ.

Gate-to-drain voltage V_{GD} EOS can be caused by a voltage between the gate and drain of a PFET that exceeds an EOS target or threshold, such as when the transistors turned-off (e.g., V_{G} is at a high voltage, such as VCC_HV). The normal mode V_{GD} EOS protection provided to MP10 and MP11 is controlled by OUT_ES_HV and OUTB_ES_HV. As previously described, OUT_ES_HV and OUTB_ES_HV have a minimum voltage of pbias_2+ 2×Vₜₚ., which ensures that the maximum V_{GD} of MP10 or MP11 is VCC_HV- (pbias_2+ 2×Vₜₚ).

The normal mode V_{GD} EOS protection provided to MP9 and MP12 is controlled by pulldown FETs MP5, MP6, and bias or offset pbias_1. Due to the pulldown configuration of MP5 and MP6, the minimum value of the drain voltage of MP9 and MP12 is pbias_1+Vₜₚ. Signal pbias_1 can be adjusted to control the level or margin of V_{GD} EOS protection. In an example, pbias_1 has a value between 0V and 0.3×VCC_HV.

Transistors MP7 and MP8 may not require V_{GS} EOS protection due to the source and gate voltages of these transistors tracking each other.

In bypass mode, EOS protection for MP9, MP10, MP11, and MP12 is provided by gate signals OUT_ES_HV and OUTB_ES_HV that switch between VCC_HV and Vₜₚ. In this operating mode, NFETs MN3, MN4, MN10 and MN11 are used to pull OUT_ES_LV and OUTB_ES_LV to VSS, bypassing MP1 and MP2 and avoiding the Vₜₚ drop obtained from MP1 and MP2. Signals OUT_ES_HV and OUTB_ES_HV are generated with a single Vₜₚ drop at the source of MP7 and MP8, thereby ensuring a minimum V_{G} of Vₜₚ at the gates of MP9, MP10, MP11, and MP12.

Bypass mode V_{GD} EOS protection for the remaining PFETs are the same as discussed for VGD EOS protection for these devices in normal mode.

As discussed herein, level shifter 400 implements the pulldown PFET provided EOS protection techniques described in the discussion of FIGS. 1-3 to provide a level shifter that is formed using thin gate oxide devices and that provides EOS protection to devices exposed to an elevated supply VCC_HV without the use of an elevated reference or ground.

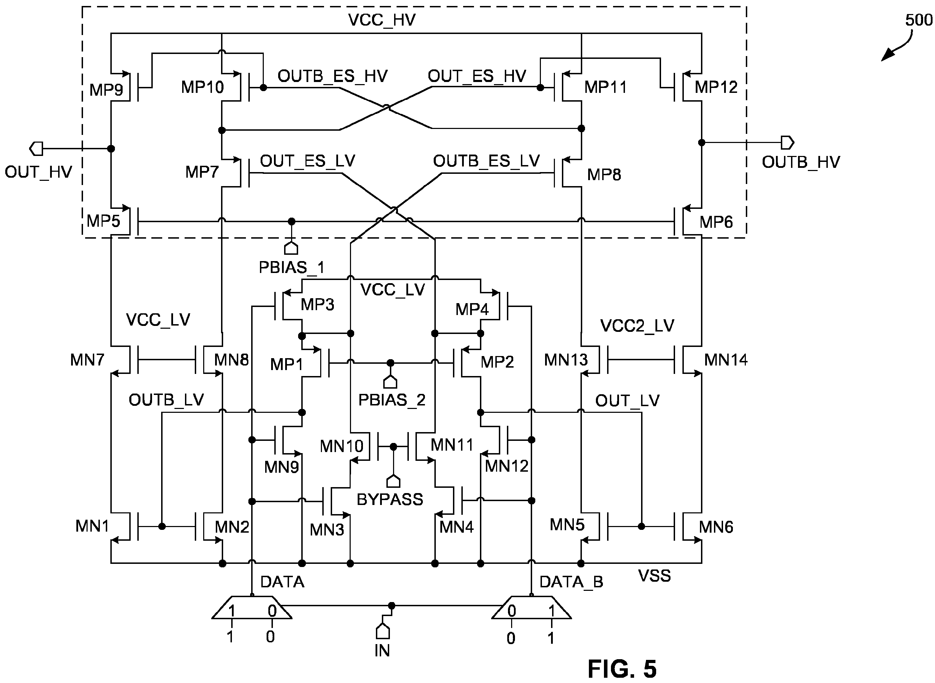

FIG. 5 illustrates a diagram of an example of a level shifter 500 that uses pulldown PFETs to provide EOS protection. Level shifter 500 is a modified version of level shifter 400, with the modification including obtaining the output of the level shifter from the source of MP5 and MP6 to limit the voltage swing of output signals OUT_HV and OUTB_HV, such as to values between VCC_HV and pbias_2+Vₜₚ. This modification can reduce the EOS impact at the output stage of level shifter 500, and thereby protect circuits connected to the output of the level shifter from EOS.

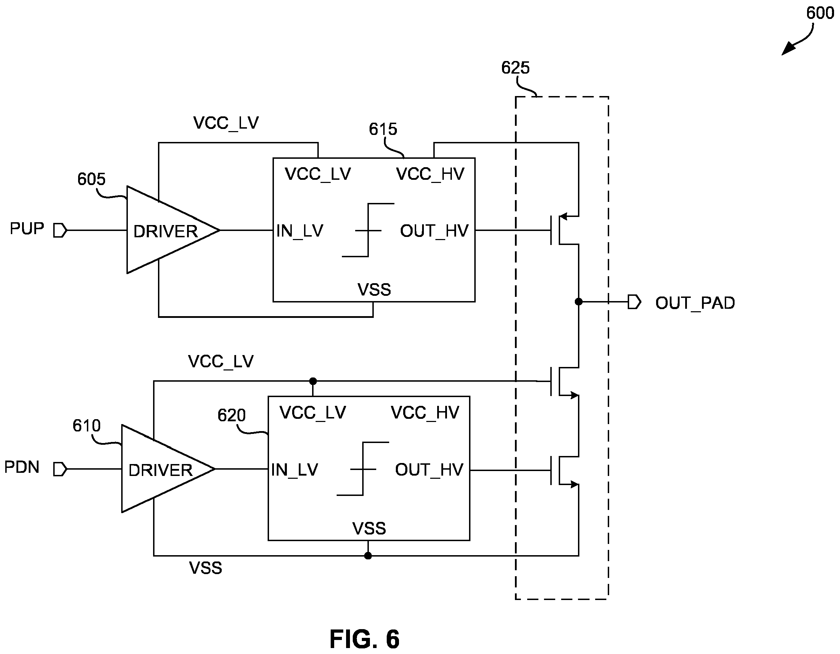

FIG. 6 illustrates a diagram of an example of output circuitry 600 for a I/O interface that includes level shifter 615 and 620 formed by thin FET devices, as described herein. In an example, output circuitry 600 includes pre-driver circuitry formed by drivers 605 and 610, level shifters 615 and 620, and output driver 625. Level shifters 615 and 620 are examples of any of the level shifters formed according to the techniques described herein. In a specific example, lever shifters 615 and 620 are included in the final stage of the pre-driver circuitry to limit the devices that are exposed to VCC_HV (e.g., an I/O supply voltage) to the devices in the level shifters and the output driver 625, while ensuring that final output signals of output circuitry 600 have a full rail-to-rail voltage swing, such as provided by final driver 625.

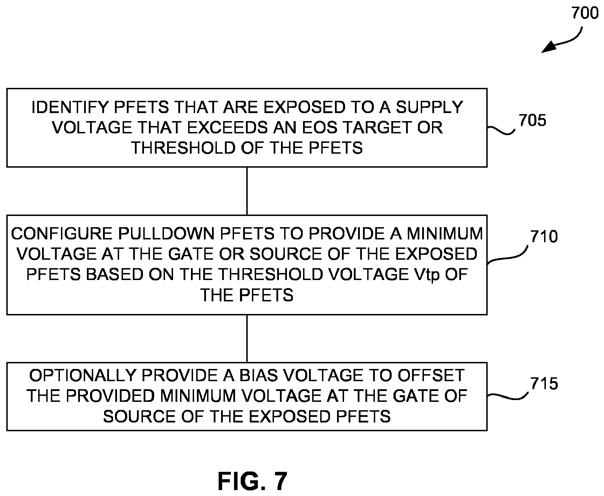

FIG. 7 illustrates steps of a process 700 for forming a level shifter that provides EOS protection to thin gate devices. Process 700 can be used, such as in a (CAD) software application, to form any of the level shifter circuitry formed according to the techniques described herein. A 705 one or more PFET devices that are exposed a supply voltage, such as VCC_HV, that exceeds an EOS target or threshold of the PFETs are identified. At 710, one or more PFETs are configured as pulldown devices to provide a minimum voltage at the gate or source of the exposed PFETs based on Vₜₚ of the pulldown devices. At 715, an optional bias or offset voltage is used to determine the a minimum voltage at the gate or source of the exposed PFETs, as described herein. Process 700 can further include any additional steps suitable for forming a level shifter according to the techniques described herein.

The circuits, circuitry, or devices illustrated in the figures and described herein are illustrated or described with respect to a specified electrical polarity, such as positive or negative voltages or currents, and device dopant or charge carrier configurations, such as PFET verses NFET or n-type material verses p-type material, to improve the clarity of the discussion. Such electrical polarities or devices dopant or charge carrier configurations can be reversed or swapped where readily appreciable without loss of generally to the techniques of devices described herein. Additionally, the present disclosure is applicable to both NFET and PFET devices.

## Claims

1. A level shifter device (400) to shift a voltage of a signal from a voltage level of first logic interface to a voltage level of a second logic interface, the device comprising:
first and second power supply nodes to couple, respectively, to first and second power supplies, wherein the first power supply (VCC_LV) has a voltage that is lower than a voltage of the second power supply (VCC_HV);
a reference node (VSS) to couple to a power supply reference that is shared by the first power supply and the second power supply;
one or more transistors (MP9, MP10, MP11, MP12) having a source terminal coupled to the second power supply node and a drain terminal coupled to the reference node to provide a shifted output signal responsive to an input signal, wherein the one or more transistors are degraded responsive to a voltage between at least two terminals of the one or more transistors exceeding a threshold value, the threshold value being smaller than a voltage difference between the second power supply and the power supply reference; and
a pulldown transistor (MP1, MP2, MP5, MP6) coupled to a first transistor of the one or more transistors to limit the voltage difference between the at least two terminals to a voltage below the threshold value based on the threshold voltage of the pulldown transistor,
wherein the pulldown transistor (MP1, MP2) is coupled to a gate terminal of the first transistor (MP10, MP11)to provide an indicated minimum gate voltage to the first transistor; or
wherein the pulldown transistor (MP5, MP6) has a first source terminal coupled to a first drain terminal of the first transistor (MP9, MP12) and is coupled between the first drain terminal of the first transistor and the reference node to provide an indicated minimum voltage at the drain terminal of the first transistor.

2. The device of claim 1, wherein at least one transistor of the one or more transistors is a p-channel field effect transistor, PFET.

3. The device of claim 1 or claim 2, wherein the pulldown transistor includes a PFET.

4. The device of any one of claims 1 to 3, wherein the pulldown transistor is configured to limit a voltage at the first drain terminal of the first transistor to at least the threshold voltage of the pulldown transistor.

5. The device of any one of claims 1 to 4, wherein the pulldown transistor is configured to limit a voltage at the gate terminal of the first transistor to at least the threshold voltage of the pulldown transistor.

6. The device of claim 1, wherein the pulldown transistor is coupled between a pullup and pulldown transistor of a buffer circuit.

7. The device of claim 2, wherein the pulldown transistor includes first and second PFETs.

8. The device of claim 7, wherein:
the first PFET includes a first drain coupled to the first power supply node and a first source coupled to the reference node; and
the second PFET includes a second drain coupled to the second power supply node and a second source coupled to the reference node.

9. The device of claim 7, further comprising a switching element that is configured to selectively bypass the first PFET.

10. A voltage level shifter method comprising:
shifting, at a level shifter device, a voltage of a signal from a voltage level of first logic interface to a voltage level of a second logic interface, the level shifter device comprising:
first and second power supply nodes coupled respectively to first and second power supplies, wherein the first power supply has a voltage that is lower than a voltage of the second power supply;
a reference node to couple to a power supply reference that is shared by the first power supply and the second power supply;
one or more transistors having a source terminal coupled to the second power supply node and a drain terminal coupled to the reference node to provide a shifted output signal responsive to an input signal, wherein the one or more transistors are degraded responsive to a voltage between at least two terminals of the one or more transistors exceeding a threshold value, the threshold value being smaller than a voltage difference between the second power supply and the power supply reference; and
a pulldown transistor coupled to a first transistor of the one or more transistors to limit the voltage difference between the at least two terminals to a voltage below the threshold value based on the threshold voltage of the pulldown transistor,
wherein the pulldown transistor has a source terminal coupled to a drain terminal of the first transistor between the drain terminal of the first transistor and the reference node, or coupled to a gate terminal of the first transistor; and to limit the voltage difference between the two terminals of the one or more transistors, the pulldown transistor is configured to provide an indicated minimum voltage at the drain terminal of the first transistor, or an indicated minimum gate voltage at the first transistor, respectively.

11. The method of claim 10, wherein the pulldown transistor is configured to limit a voltage at the respective drain or gate terminals of the one or more transistors to at least the threshold voltage of the pulldown transistor.

12. The method of claim 10 , wherein at least one transistor of the one or more transistors is a p-channel field effect transistor, PFET.

13. The method of claim 10, wherein the pulldown transistor includes a PFET.

14. A computer program comprising computer program code for performing the method of any one of claims 10 to 13.

## Patentansprüche

1. Pegelwandlervorrichtung (400) zum Verschieben einer Spannung eines Signals von einem Spannungspegel einer ersten Logikschnittstelle zu einem Spannungspegel einer zweiten Logikschnittstelle, wobei die Vorrichtung umfasst:
einen ersten und einen zweiten Energieversorgungsknoten, um mit einer ersten bzw. einer zweiten Energieversorgung gekoppelt zu werden, wobei die erste Energieversorgung (VCC_LV) eine Spannung aufweist, die niedriger als eine Spannung der zweiten Energieversorgung (VCC_HV) ist;
einen Referenzknoten (VSS), um mit einer Energieversorgungsreferenz gekoppelt zu werden, die von der ersten Energieversorgung und der zweiten Energieversorgung gemeinsam genutzt wird;
einen oder mehrere Transistoren (MP9, MP10, MP11, MP12), die einen Source-Anschluss, der mit dem zweiten Energieversorgungsknoten gekoppelt ist, und einen Drain-Anschluss aufweisen, der mit dem Referenzknoten gekoppelt ist, um ein verschobenes Ausgangssignal als Reaktion auf ein Eingangssignal bereitzustellen, wobei der eine oder die mehreren Transistoren als Reaktion darauf beeinträchtigt werden, dass eine Spannung zwischen mindestens zwei Anschlüssen des einen oder der mehreren Transistoren einen Schwellenwert überschreitet, wobei der Schwellenwert kleiner als eine Spannungsdifferenz zwischen der zweiten Energieversorgung und der Energieversorgungsreferenz ist; und
einen Pulldown-Transistor (MP1, MP2, MP5, MP6), der mit einem ersten Transistor des einen oder der mehreren Transistoren gekoppelt ist, um die Spannungsdifferenz zwischen den mindestens zwei Anschlüssen basierend auf der Schwellenspannung des Pulldown-Transistors auf eine Spannung unterhalb des Schwellenwerts zu begrenzen,
wobei der Pulldown-Transistor (MP1, MP2) mit einem Gate-Anschluss des ersten Transistors (MP10, MP11) gekoppelt ist, um eine angezeigte minimale Gate-Spannung für den ersten Transistor bereitzustellen; oder
wobei der Pulldown-Transistor (MP5, MP6) einen ersten Source-Anschluss aufweist, der mit einem ersten Drain-Anschluss des ersten Transistors (MP9, MP12) gekoppelt ist, und zwischen den ersten Drain-Anschluss des ersten Transistors und den Referenzknoten gekoppelt ist, um eine angezeigte Mindestspannung an dem Drain-Anschluss des ersten Transistors bereitzustellen.

2. Vorrichtung nach Anspruch 1, wobei mindestens ein Transistor des einen oder der mehreren Transistoren ein p-Kanal-Feldeffekttransistor, PFET, ist.

3. Vorrichtung nach Anspruch 1 oder Anspruch 2, wobei der Pulldown-Transistor einen PFET aufweist.

4. Vorrichtung nach einem der Ansprüche 1 bis 3, wobei der Pulldown-Transistor konfiguriert ist, um eine Spannung an dem ersten Drain-Anschluss des ersten Transistors mindestens auf die Schwellenspannung des Pulldown-Transistors zu begrenzen.

5. Vorrichtung nach einem der Ansprüche 1 bis 4, wobei der Pulldown-Transistor konfiguriert ist, um eine Spannung an dem Gate-Anschluss des ersten Transistors mindestens auf die Schwellenspannung des Pulldown-Transistors zu begrenzen.

6. Vorrichtung nach Anspruch 1, wobei der Pulldown-Transistor zwischen einen Pullup- und Pulldown-Transistor einer Pufferschaltung gekoppelt ist.

7. Vorrichtung nach Anspruch 2, wobei der Pulldown-Transistor einen ersten und einen zweiten PFET beinhaltet.

8. Vorrichtung nach Anspruch 7, wobei:
der erste PFET einen ersten Drain, der mit dem ersten Energieversorgungsknoten gekoppelt ist, und eine erste Source aufweist, die mit dem Referenzknoten gekoppelt ist; und
der zweite PFET einen zweiten Drain, der mit dem zweiten Energieversorgungsknoten gekoppelt ist, und eine zweite Source aufweist, die mit dem Referenzknoten gekoppelt ist.

9. Vorrichtung nach Anspruch 7, die ferner ein Schaltelement umfasst, das konfiguriert ist, um den ersten PFET selektiv zu überbrücken.

10. Spannungspegelwandlerverfahren, umfassend: Verschieben, in einer Pegelwandlervorrichtung, einer Spannung eines Signals von einem Spannungspegel einer ersten Logikschnittstelle zu einem Spannungspegel einer zweiten Logikschnittstelle, wobei die Pegelwandlervorrichtung umfasst:
einen ersten und einen zweiten Energieversorgungsknoten, die mit einer ersten bzw. einer zweiten Energieversorgung gekoppelt sind, wobei die erste Energieversorgung eine Spannung aufweist, die niedriger als eine Spannung der zweiten Energieversorgung ist;
einen Referenzknoten, um mit einer Energieversorgungsreferenz gekoppelt zu werden, die von der ersten Energieversorgung und der zweiten Energieversorgung gemeinsam genutzt wird;
einen oder mehrere Transistoren, die einen Source-Anschluss, der mit dem zweiten Energieversorgungsknoten gekoppelt ist, und einen Drain-Anschluss aufweisen, der mit dem Referenzknoten gekoppelt ist, um ein verschobenes Ausgangssignal als Reaktion auf ein Eingangssignal bereitzustellen, wobei der eine oder die mehreren Transistoren als Reaktion darauf beeinträchtigt werden, dass eine Spannung zwischen mindestens zwei Anschlüssen des einen oder der mehreren Transistoren einen Schwellenwert überschreitet, wobei der Schwellenwert kleiner als eine Spannungsdifferenz zwischen der zweiten Energieversorgung und der Energieversorgungsreferenz ist; und
einen Pulldown-Transistor, der mit einem ersten Transistor des einen oder der mehreren Transistoren gekoppelt ist, um die Spannungsdifferenz zwischen den mindestens zwei Anschlüssen basierend auf der Schwellenspannung des Pulldown-Transistors auf eine Spannung unterhalb des Schwellenwerts zu begrenzen,
wobei der Pulldown-Transistor einen ersten Source-Anschluss aufweist, der mit einem ersten Drain-Anschluss des ersten Transistors zwischen dem Drain-Anschluss des ersten Transistors und dem Referenzknoten gekoppelt ist oder mit einem Gate-Anschluss des ersten Transistors gekoppelt ist; und um die Spannungsdifferenz zwischen den beiden Anschlüssen des einen oder der mehreren Transistoren zu begrenzen, wobei der Pulldown-Transistor konfiguriert ist zum Bereitstellen einer angezeigten Mindestspannung an dem Drain-Anschluss des ersten Transistors bzw. einer angezeigten minimalen Gate-Spannung des ersten Transistors.

11. Verfahren nach Anspruch 10, wobei der Pulldown-Transistor konfiguriert ist, um eine Spannung an den jeweiligen Drain- oder Gate-Anschlüssen des einen oder der mehreren Transistoren mindestens auf die Schwellenspannung des Pulldown-Transistors zu begrenzen.

12. Verfahren nach Anspruch 10, wobei mindestens ein Transistor des einen oder der mehreren Transistoren ein p-Kanal-Feldeffekttransistor, PFET, ist.

13. Verfahren nach Anspruch 10, wobei der Pulldown-Transistor einen PFET aufweist.

14. Computerprogrammprodukt, das einen Computerprogrammcode zum Durchführen des Verfahrens nach einem der Ansprüche 10 bis 13 umfasst.

## Revendications

1. Dispositif de décalage de niveau (400) pour décaler une tension d'un signal d'un niveau de tension d'une première interface logique à un niveau de tension d'une deuxième interface logique, le dispositif comprenant :
des premier et deuxième nœuds d'alimentation devant être couplés respectivement à des première et deuxième alimentations, dans lequel la première alimentation (VCC_LV) présente une tension inférieure à une tension de la deuxième alimentation (VCC_HV),
un nœud de référence (VSS) destiné à être couplé à une référence d'alimentation partagée par la première alimentation et la deuxième alimentation,
un ou plusieurs transistors (MP9, MP10, MP11, MP12) ayant une borne de source couplée au deuxième nœud d'alimentation et une borne de drain couplée au nœud de référence pour fournir un signal de sortie décalé en réponse à un signal d'entrée, dans lequel le ou les transistors sont dégradés en réponse au fait qu'une tension entre au moins deux bornes du ou des transistors dépasse une valeur de seuil, la valeur de seuil étant inférieure à une différence de tension entre la deuxième alimentation et la référence d'alimentation ; et
un transistor d'excursion basse (MP1, MP2, MP5, MP6) couplé à un premier transistor parmi le ou les transistors pour limiter la différence de tension entre les au moins deux bornes à une tension inférieure à la valeur de seuil en fonction de la tension de seuil du transistor d'excursion basse,
dans lequel le transistor d'excursion basse (MP1, MP2) est couplé à une borne de grille du premier transistor (MP10, MP11) pour fournir une tension de grille minimale indiquée au premier transistor ; ou
dans lequel le transistor d'excursion basse (MP5, MP6) a une première borne de source couplée à une première borne de drain du premier transistor (MP9, MP12) et est couplé entre la première borne de drain du premier transistor et le nœud de référence pour fournir une tension minimale indiquée à la borne de drain du premier transistor.

2. Dispositif selon la revendication 1, dans lequel au moins un transistor parmi le ou les transistors est un transistor à effet de champ à canal P, PFET.

3. Dispositif selon la revendication 1 ou la revendication 2, dans lequel le transistor d'excursion basse comprend un PFET.

4. Dispositif selon l'une quelconque des revendications 1 à 3, dans lequel le transistor d'excursion basse est configuré pour limiter une tension sur la première borne de drain du premier transistor à au moins la tension de seuil du transistor d'excursion basse.

5. Dispositif selon l'une quelconque des revendications 1 à 4, dans lequel le transistor d'excursion basse est configuré pour limiter une tension sur la borne de grille du premier transistor à au moins la tension de seuil du transistor d'excursion basse.

6. Dispositif selon la revendication 1, dans lequel le transistor d'excursion basse est couplé entre un transistor d'excursion haute et un transistor d'excursion basse d'un circuit tampon.

7. Dispositif selon la revendication 2, dans lequel le transistor d'excursion basse comprend des premier et deuxième PFET.

8. Dispositif selon la revendication 7, dans lequel :
le premier PFET comprend un premier drain couplé au premier nœud d'alimentation et une première source couplée au nœud de référence ; et
le second PFET comprend un second drain couplé au deuxième nœud d'alimentation et une deuxième source couplée au nœud de référence.

9. Dispositif selon la revendication 7, comprenant en outre un élément de commutation qui est configuré pour contourner sélectivement le premier PFET.

10. Procédé de décalage de niveau de tension comprenant :
le décalage, sur un dispositif de décalage de niveau, d'une tension d'un signal d'un niveau de tension d'une première interface logique à un niveau de tension d'une deuxième interface logique, le dispositif de décalage de niveau comprenant :
des premier et deuxième nœuds d'alimentation couplés respectivement à des première et deuxième alimentations, dans lequel la première alimentation présente une tension inférieure à une tension de la deuxième alimentation ;
un nœud de référence devant être couplé à une référence d'alimentation partagée par la première alimentation et la deuxième alimentation ;
un ou plusieurs transistors ayant une borne de source couplée au deuxième nœud d'alimentation et une borne de drain couplée au nœud de référence pour fournir un signal de sortie décalé en réponse à un signal d'entrée, dans lequel le ou les transistors sont dégradés en réponse au fait qu'une tension entre au moins deux bornes du ou des transistors dépasse une valeur de seuil, la valeur de seuil étant inférieure à une différence de tension entre la deuxième alimentation et la référence d'alimentation ; et
un transistor d'excursion basse couplé à un premier transistor parmi le ou les transistors pour limiter la différence de tension entre les au moins deux bornes à une tension inférieure à la valeur de seuil en fonction de la tension de seuil du transistor d'excursion basse,
dans lequel le transistor d'excursion basse a une borne de source couplée à une borne de drain du premier transistor entre la borne de drain du premier transistor et le nœud de référence, ou couplée à une borne de grille du premier transistor ; et pour limiter la différence de tension entre les deux bornes du ou des transistors, le transistor d'excursion basse est configuré pour fournir respectivement une tension minimale indiquée sur la borne de drain du premier transistor, ou une tension de grille minimum indiquée sur le premier transistor.

11. Procédé selon la revendication 10, dans lequel le transistor d'excursion basse est configuré pour limiter une tension aux bornes de drain ou de grille respectives du ou des transistors à au moins la tension de seuil du transistor d'excursion basse.

12. Procédé selon la revendication 10, dans lequel au moins un transistor parmi le ou les transistors est un transistor à effet de champ à canal P, PFET.

13. Procédé selon la revendication 10, dans lequel le transistor d'excursion basse comprend un PFET.

14. Programme informatique comprenant un code de programme informatique pour mettre en œuvre le procédé selon l'une quelconque des revendications 10 à 13.
